# EUROPÄISCHE PATENTSCHRIFT

(11) **EP 0 725 994 B1**
(45) Veröffentlichungstag und Bekanntmachung des Hinweises auf die Patenterteilung: **11.06.1997**
(21) Anmeldenummer: 94929406.0
(22) Anmeldetag: 20.10.1994
(51) Int. Cl.: H02J 3/42, G01R 31/00

(54) **EINRICHTUNG ZUR LEISTUNGSSCHALTER-EIGENZEITMESSUNG**
DEVICE FOR MEASURING THE TIME ELEMENT OF A POWER SWITCH
DISPOSITIF PERMETTANT DE MESURER LE TEMPS DE MAN UVRE D'UN SECTIONNEUR DE PUISSANCE

(30) Priorität: 28.10.1993 AT 2170/93
(43) Veröffentlichungstag der Anmeldung: 14.08.1996
(73) Patentinhaber: ELIN ENERGIEVERSORGUNG GESELLSCHAFT m.b.H., 1141 Wien (AT)
(72) Erfinder: CECH, Michael, A-2432 Schwadorf (AT)
(74) Vertreter: Krause, Peter
(86) Internationale Anmeldenummer: AT9400152
(87) Internationale Veröffentlichungsnummer: WO9512236

(56) Entgegenhaltungen:
- DE-A- 1 957 694
- DE-U- 9 307 585
- FR-A- 2 225 864
- ELEKTROTECHNISCHE ZEITSCHRIFT, AUSGABE B, Bd.26, Nr.19, 1974, BERLIN ,DE, Seiten 184 - 186; D. KLEIN: 'Zeitmessung an relais'

## Beschreibung

Die Erfindung betrifft eine Einrichtung zur Leistungsschalter-Eigenzeitmessung für die Synchronisierung von zwei elektrischen Netzsystemen, wobei für jedes Netzsystem ein Spannungswandler zur Messung der Spannungen beidseitig eines als Leistungsschalter ausgeführten Kuppelschalters vorgesehen ist.

Wesentlich bei der Synchronisierung zweier elektrischer Netzsysteme ist das Schließen eines Leistungsschalters, und damit das Verbinden der beiden Systeme. Als Voraussetzung dazu müssen die Frequenz- und Spannungsdifferenzen innerhalb eines Toleranzfeldes sein. Eine weitere Forderung besteht darin, daß der Phasenwinkel der beiden Systeme zueinander möglichst Null Grad elektrisch ist. Wird die "EIN"-Spule eines Leistungsschalters erregt, so vergeht eine bestimmte Zeit, bis die Hauptkontakte geschlossen und beide Systeme verbunden sind. Diese Zeitdauer ab dem Moment, in welchem das Steuergerät seinen Ausgangskontakt schließt, bis zu dem Zeitpunkt, ab welchem die Systeme miteinander verbunden sind, wird als Leistungsschalter-Eigenzeit bezeichnet. Diese Zeitdauer wird als Zeitkonstante in ein Synchronisiergerät eingegeben und von diesem durch entsprechend vorzeitiges Schalten berücksichtigt.

Bisher wurde die Leistungsschalter-Eigenzeit folgendermaßen gemessen: Die Hauptkontakte des Leistungsschalters wurden aus der Schaltanlage herausgelöst und mit dem Stoppkontakt einer Meßuhr verbunden. Mittels eines Schalters wurden gleichzeitig die "EIN"-Kreise des Leistungsschalters und einer Meßuhr gestartet. Wenn nach Ablauf der Leistungsschalter-Eigenzeit die Hauptkontakte geschlossen waren, hielt die Meßuhr an, die Zeitdauer konnte abgelesen werden.

Nachteilig an dieser Meßmethode ist der immense Zeitaufwand, der notwendig ist, um die Hauptkontakte aus der Schaltanlage herauszulösen und anschließend wieder einzubinden. Dazu kommt als weiterer Nachteil, daß eine Hilfssteuerleitung zu verlegen ist, um die Meßuhr anzusteuern.
Aufgabe der Erfindung ist es, eine Einrichtung zur Leistungsschalter-Eigenzeitmessung zu konzipieren, mit deren Hilfe die Messung auf einfache Art durchführbar ist.

Die Aufgabe wird durch die Erfindung gelöst. Diese ist in Anspruch 1 definiert.

Mit der Erfindung ist es möglich, die Leistungsschalter-Eigenzeiten auf einfache Art zu messen, ohne dabei irgendwelche Arbeiten in der Schaltanlage durchführen zu mussen.

In einer Weiterbildung der Erfindung erfolgen Messungen der Differenz der Momentanwerte zwischen dem jeweils festen Schaltkontakt und dem zugehörigen beweglichen Schaltkontakt der Hauptkontakte aller Phasen des Leistungsschalters innerhalb eines Meßvorganges, wobei das Spannungsmeßmodul und das Zeitmeßmodul entsprechend erweitert sind, und daß der Rechner den Mittelwert der gemessenen Zeiten zur Ablesung ausgibt.

Der Vorteil dieser Weiterbildung besteht, durch die Ermittlung eines Mittelwertes, in einer erhöhten Genauigkeit der Zeitmessung.
Im Rahmen der Erfindung ist vorgesehen, daß der Rechner die Ermittlung der Leistungsschalter-Eigenzeit mittels eines Programmes selbsttätig durchführt. Dadurch ist es möglich, die erfindungsgemäße Einrichtung in eine vollautomatische Anlage einzubinden.

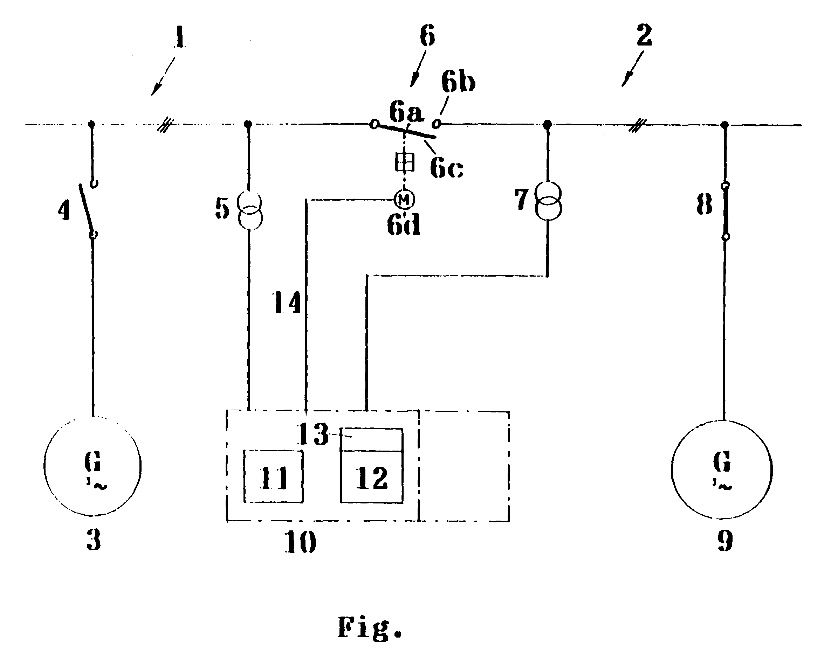

Anhand eines in der Zeichnung dargestellten Ausführungsbeispieles soll die Erfindung näher erläutert werden.

Die Fig. zeigt ein erstes elektrisches Netzsystem 1 und ein zweites elektrisches Netzsystem 2, welche über einen als Leistungsschalter ausgeführten Kuppelschalter 6 miteinander verbindbar sind. Das zweite Netzsystem 2 ist über einen Generatorschalter 8 von einem Generator 9 gespeist, wobei der Generatorschalter 8 geschlossen, das Netzsystem 2 somit spannungführend ist. Das erste Netzsystem 1 wird über einen Generatorschalter 4 von einem Generator 3 gespeist, wobei der Generatorschalter 4 geöffnet, das Netzsystem 1 somit spannungslos ist.
Einem Rechner 10, welcher ein Spannungsmeßmodul 11 und ein Zeitmeßmodul 12 sowie ein Display 13 beinhaltet, wird über zwei Spannungswandler 5, 7 die Spannung des ersten und des zweiten Netzsystemes 1, 2 - das entspricht den Spannungen am beweglichen Schaltkontakt 6c und am festen Schaltkontakt 6b eines Hauptkontaktes 6a einer Phase des Leistungschalters 6 - zugeführt. Eine Steuerleitung 14 ist zur Übertragung der Schaltbefehle an den Antriebsmotor 6d des Leistungsschalters 6 vorgesehen.

Der als Leistungsschalter ausgeführte Kuppelschalter 6, dessen Eigenzeit gemessen werden soll, weist vor Meßbeginn offene Schaltposition auf während nur eines - im vorliegenden Fall das zweite Netzsystem 2 - der beiden zu synchronisierenden Netzsysteme 1, 2 Spannung führt. Nach erfolgter Initierung gibt der Rechner (10) einen Schaltbefehl an den Leistungsschalter 6 ab und startet gleichzeitig eine Zeitstufe im Zeitmeßmodul 12. Ab diesem Zeitpunkt mißt das Spannungsmeßmodul 11 über die Spannungswandler 7, 5 die Differenz der Momentanwerte zwischen dem festen Schaltkontakt 6b und dem beweglichen Schaltkontakt 6c des Hauptkontaktes 6a einer Phase des Leistungsschalters 6.
Wenn der Hauptkontakt 6a geschlossen hat, beträgt die Differenz der Momentanwerte der Spannungen Null; jedoch ergibt auch jeder Nulldurchgang der Referenzspannung, solange der Leistungsschalter 6 noch nicht geschlossen ist, eine Nulldifferenz, die ein Ende der Messung erzielen würde. Unter der Annahme einer Betriebsfrequenz von 50 Hz ist. um diese Nulldurchgänge auszufiltern, ein Toleranzfenster von 3 % der Nennspannung eingerichtet und dazu die Bedingung definiert, daß die Differenzspannung zwischen den beiden Netzsystemen 1, 2 mindestens 5 Millisekunden lang das Toleranzfenster unterschreiten muß.

Ist der Hauptkontakt 6a des Leistungsschalters 6 noch offen, so tritt zwar alle 10 Millisekunden ein Nulldurchgang auf und die Toleranzgrenze wird unterschritten, allerdings bei 3 % der Nennspannung nur für 0,2 Millisekunden, wodurch die Zeitdauerbedingung nicht erfüllt wird.

Schließt der Hauptkontakt 6a, so wird - bei ausreichender Genauigkeit der verwendeten Spannungswandler 5, 7 - die Toleranzgrenze dauernd unterschritten, damit die Zeitbedingung erfüllt und die Messung beendet. Die Zeitdauer von 5 Millisekunden kann deswegen gewählt werden. weil die damit verbundene Meßunschärfe immer noch jenseits der tatsächlich erforderlichen Meßgenauigkeit liegt. In der Praxis streuen Einzelmessunoen von Leistungsschalter-Eigenzeiten um mehr als 20 Millisekunden.

Auf diese Weise ist es moglich, die Eigenzeit eines Leistungsschalters rasch und einfach zu messen, ohne zuvor Arbeiten an der Schaltanlage durchführen zu müssen.

## Patentansprüche

1. Einrichtung zur Leistungsschalter-Eigenzeitmessung für die Synchronisierung von zwei elektrischen Netzsystemen (1, 2), wobei für jedes Netzsystem (1 bzw. 2) ein Spannungswandler (5 bzw. 7) zur Messung der Spannungen beidseitig eines als Leistungsschalter (6) ausgeführten Kuppelschalters vorgesehen ist, **dadurch gekennzeichnet,** daß die Einrichtung einen Rechner enthält, der die Ermittlung der Leistungsschalter-Eigenzeit durchführt, wobei der Rechner ein Spannungsmeßmodul (11) sowie ein Zeitmeßmodul (12) und ein Display (13) beinhaltet, wobei die Leistungsschalter-Eigenzeitmessung zu einem Zeitpunkt erfolgt, zu welchem nur ein Netzsystem (2) Spannung führt, wenn der zu messende Leistungsschalter (6) vor Meßbeginn geöffnete Schaltposition aufweist, und daß die Sekundärseiten der Spannungswandler (5, 7) dem Rechner (10) zugeführt sind, und daß das Spannungsmeßmodul (11) die Differenz der Momentanwerte zwischen dem festen Schaltkontakt (6b) und dem beweglichen Schaltkontakt (6c) des Hauptkontaktes (6a) einer Phase mißt, und daß Meßbeginn der Zeitpunkt der Schaltbefehlsgabe "EIN" an den Leistungsschalter (6) ist, und daß eine Zeitstufe des Zeitmeßmoduls (12) bei Meßbeginn startet und bei Meßende anhält, und daß als Meßende jener Zeitpunkt definiert ist, bei welchem die Differenzspannung zwischen den beiden Netzsystemen (1, 2) einen geringen, definierten Prozentsatz der Nennspannung eine geringe, definierte Zeitdauer lang unterschreitet, wobei die Höhe dieses Prozentsatzes sowie diese Zeitdauer je nach Betriebsverhältnissen wählbar sind, im wesentlichen jedoch einem Wert von etwa 3 % der Nennspannung sowie, bei einer Betriebsfrequenz von 50 Hz, einer Zeitdauer von etwa 5 Millisekunden entsprechen, und daß die gemessene Zeitdauer zur Ablesung an das Display (13) ausgebbar ist.

2. Einrichtung zur Leistungsschalter-Eigenzeitmessung nach Anspruch 1, **dadurch gekennzeichnet,** daß Messungen der Differenz der Momentanwerte zwischen dem jeweils festen Schaltkontakt (6b) und dem zugehörigen beweglichen Schaltkontakt (6c) der Hauptkontakte (6a) aller Phasen des Leistungsschalters (6) innerhalb eines Meßvorganges erfolgen, wobei das Spannungsmeßmodul (11) und das Zeitmeßmodul (12) entsprechend erweitert sind, und daß der Rechner (10) den Mittelwert der gemessenen Zeiten zur Ablesung ausgibt.

3. Einrichtung zur Leistungsschalter-Eigenzeitmessung nach Anspruch 1, **dadurch gekennzeichnet,** daß der Rechner (10) die Ermittlung der Leistungsschalter-Eigenzeit mittels eines Programmes selbsttätig durchführt.

## Claims

1. A device for measuring the characteristic period of a power disconnecting switch for synchronizing two electrical network systems (1, 2), a voltage transformer (5 respectively 7) being provided for each network system (1 respectively 2) so as to measure voltages on both sides of a coupling breaker in the form of a power disconnecting switch (6), characterized in that said device includes a computer which carries out the operation of determining the characteristic period of said power disconnecting switch, with said computer including a voltage measuring module (11) as well as a time measuring module (12) and a display (13), the operation of measuring the characteristic period of said power disconnecting switch taking place at a moment where voltage is provided by only a network system (2) when said power disconnecting switch (6) to be measured exhibits an open switching position before said measuring operation starts; in that the voltage transformer (5, 7) secondary windings are connected to said computer (10); in that said voltage measuring module (11) measures a difference of instantaneous values between the fixed switching contact (6b) and the movable switching contact (6c) of a phase main contact (6a); in that the measuring operation beginning is the moment when an "on" switching command is delivered to said power disconnecting switch (6); in that a time range for said time measuring module (12) is started when said measuring operation begins and is stopped when said measuring operation ends; and in that the end of said measuring operation is defined by the instant when voltage difference between said both network systems (1, 2) is below a set low percentage of the rated voltage, during a set low duration, with the value of said percentage as well as said duration being selected according to the operating conditions, but, however, substantially corresponding to a value of about 3 % of the rated voltage, and, with an operating frequency of 50 Hz, to a duration of about 5 ms; and in that the measured duration can be delivered to the display (13) to be read.

2. The device for measuring the characteristic period of a power disconnecting switch as recited in claim 1, characterized in that measures of instantaneous value difference between said fixed switching contact (6b) and said associated movable switching contact (6c) of each main contact (6a) of all the phases of said power disconnecting switch (6) are carried out during a measuring phase, said voltage measuring module (11) and said time measuring module (12) being extended accordingly, and in that said computer (10) delivers, for reading purposes, the measured time mean.

3. The device for measuring the characteristic period of a power disconnecting switch as recited in claim 1, characterized in that said computer (10) automatically carries out the determination operation of said characteristic period of the power disconnecting switch, with the help of a program.

## Revendications

1. Dispositif pour mesurer le temps propre d'un sectionneur de puissance pour la synchronisation de deux systèmes de réseau électriques (1, 2), un transformateur de tension (5 respectivement 7) étant prévu pour chaque système de réseau (1 respectivement 2) pour mesurer les tensions de part et d'autre d'un disjoncteur de couplage réalisé sous la forme d'un sectionneur de puissance (6), **caractérisé** en ce que le dispositif renferme un calculateur qui effectue la détermination du temps propre du sectionneur de puissance, le calculateur renfermant un module de mesure de tension (11), ainsi qu'un module de mesure de temps (12) et un écran (13), la mesure du temps propre du sectionneur de puissance étant effectuée en un instant où seul un système de réseau (2) fournit de la tension, lorsque le sectionneur de puissance (6) à mesurer présente la position de commutation ouverte avant le début de la mesure, en ce que les secondaires des transformateurs de tension (5, 7) sont raccordés au calculateur (10), en ce que le module de mesure de tension (11) mesure la différence des valeurs instantanées entre le contact de commutation fixe (6b) et le contact de commutation mobile (6c) du contact principal (6a) d'une phase, en ce que le début de mesure est constitué par l'instant de l'ordre de commutation "marche" délivré au sectionneur de puissance (6), en ce qu'une plage de temps du module de mesure de temps (12) est démarrée lors du début de mesure et s'arrête à la fin de mesure, et en ce que l'on définit en guise de fin de mesure, l'instant où la différence de tension entre les deux systèmes de réseau (1, 2) se situe en-dessous d'un faible pourcentage défini de la tension nominale, pendant une faible durée définie, la valeur de ce pourcentage ainsi que cette durée pouvant être sélectionnées en fonction des conditions de fonctionnement, mais correspondant toutefois sensiblement à une valeur d'environ 3% de la tension nominale, et, pour une fréquence de fonctionnement de 50 Hz, à une durée d'environ 5 millisecondes, et en ce que la durée mesurée peut être délivrée à l'écran (13) pour y être lue.

2. Dispositif pour mesurer le temps propre d'un sectionneur de puissance, selon la revendication 1, **caractérisé** en ce que l'on effectue des mesures de la différence des valeurs instantanées entre le contact de commutation fixe (6b) et le contact de commutation mobile (6c) associé de chacun des contacts principaux (6a) de toutes les phases du sectionneur de puissance (6) durant une phase de mesure, le module de mesure de tension (11) et le module de mesure de temps (12) étant étendu en conséquence, et en ce que le calculateur (10) délivre, pour la lecture, la valeur moyenne des temps mesurés.

3. Dispositif pour mesurer le temps propre d'un sectionneur de puissance, selon la revendication 1, **caractérisé** en ce que le calculateur (10) effectue la détermination du temps propre du sectionneur de puissance, de manière automatique, à l'aide d'un programme.
